# EUROPEAN PATENT APPLICATION

(11) **EP 1 862 287 A1**
(43) Date of publication of application: **05.12.2007**
(21) Application number: 05727032.4
(22) Date of filing: 22.03.2005
(51) Int. Cl.: B29C 39/02, B29C 39/22

(54) **PROCESS FOR PRODUCING MOLDED PART AND MOLDING APPARATUS**

(71) Applicant: Fujitsu Ltd., Kawasaki-shi, Kanagawa 211-8588 (JP)
(72) Inventor: IIDA, Susumu c/o FUJITSU LIMITED, Kawasaki-shi, Kanagawa 2118588 (JP); MATSUSHITA, Naohisa c/o FUJITSU LIMITED, Kawasaki-shi, Kanagawa 2118588 (JP); FURUI, Toshikazu c/o FUJITSU LIMITED, Kawasaki-shi, Kanagawa 2118588 (JP)
(74) Representative: Seeger, Wolfgang
(86) International application number: PCT/JP2005/005139
(87) International publication number: WO 2006/100755

(57) **Abstract**

Light (27) is irradiated to a light curing resin material (41) within a mold (24, 25). The light (27) penetrates through the light curing resin material (41) at a position off a mask (35). The light curing resin material (41) gets cured at the position off the mask (35). The mold (24, 25) in this manner serves to form the contour of a molded product. On the other hand, the mask (35) partly blocks the light (27). An uncured section (42) is established in the light curing resin material (41) behind the mask (35). When the light curing resin material (41) is removed from the uncured section (42), the uncured section provides a hole, for example. If the mask (35) is finely formed, it is possible to form a fine hole in an easier manner in a shorter time. It is possible to realize the mass production of a molded product having a fine hole.

## Description

### FIELD OF THE INVENTION

The present invention relates to a method of making a molded product.

### BACKGROUND ART

A so-called optical molding is well known. A transparent mold defining a predetermined cavity is prepared for the optical molding, for example. Light is emitted to a light curing resin material poured into the cavity. The light curing resin material gets cured in response to the emitted light. The light curing resin material is then taken out of the mold. A molded product is made in this manner.
Patent Publication 1: Japanese Patent No. 3224299
Patent Publication 2: Japanese Patent No. 3008216

### DISCLOSURE OF THE INVENTION

A fine pin can be utilized to form a fine hole on the molded product. The pin is fixed to the mold within the cavity, for example. In this case, when the light curing resin material is poured into the mold, the flow of the light curing resinmaterial generates the urging force to break the pin. The pin can also be broken when the cured light curing resin material is taken out of the mold. The pin cannot thus be formed in the mold.

It is accordingly an object of the present invention to provide a method of making a molded product and a molding apparatus, capable of forming a fine hole on the molded product in a facilitated manner.

According to a first aspect of the present invention, there is provided a method of making a moldedproduct, comprising: pouring a light curing resin material into a mold; emitting light to the light curing resin material, the light beingpartlyblocked with a mask; and removing an uncured portion of the light curing resin material, the uncured portion remaining uncured based on blockage of the light.

The method allows the light to penetrate through the light curing resin material at a position off the mask. The light curing resin material gets cured at the position off the mask. The mold thus forms the contour of a molded product. The mask serves to partly block the light directed toward the light curing resin material. This results in establishment of the uncured section in the light curing resin material below the mask. The light curing resin material is removed from the uncured section in the light curing resin material. The uncured section in this manner provides a hole, for example. Since the shape of the cross-section of the uncured section reflects the shape of the mask, the cross-section of the hole can be determined depending on the shape of the mask. This results in an easier realization of the mass production of the molded product having the hole. If the mask is finely formed, for example, it is possible to form a fine hole in an easier manner in a shorter time. Moreover, since the mask takes any shape, the hole can take a variety of shapes.

The method further may comprise absorbing the light that penetrates through the mold. This results in prevention of reflection of the light toward the mold. The emitted light is prevented from reaching the aforementioned uncured section. The uncured section thus reflects the shape of the mask with accuracy. In this case, the surface of the mold may be subjected to a surface treatment for absorption of light, for example.

The method may further comprise emitting light to the light curing resin material behind the mask. The aforementioned uncured section is at least partly exposed to the light in this manner. The uncured section is completely surrounded by the light curing resin material in a solid state. A bottomed hole, for example, can thus be formed in a facilitated manner.

The mask may be fixed to the mold for blockage of the emitted light. Since the mask is fixed to the mold, the aforementioned uncured section can be formed at the same position with accuracy in every molded product. The molded product can thus be mass-produced as designed with a higher accuracy.

According to a second aspect of the present invention, there is provided a method of making a moldedproduct, comprising: pouring a light curing resin material into a mold; emitting light to the light curing resin material in a first direction, the light being partly blocked with a mask; emitting light to the mask in a second direction opposite to the first direction; and removing an uncured portion of the light curing resin material, the uncured portion remaining uncured based on blockage of the light.

The method allows the light in the first direction to penetrate through the light curing resin material at a position off the mask. The light curing resin material gets cured at the position off the mask. The mask serves to partly block the light directed toward the light curing resin material. This results in establishment of an uncured section in the light curing resin material behind the mask. On the other hand, the light in the second direction opposite to the first direction is directed to the mask. The light curing resin material gets cured behind the mask. If the light in the second direction is subjected to adjustment of the intensity and the duration of emission, an uncured section is formed behind the mask, for example. If an uncured portion is excluded from the uncured section in the light curing resin material, the uncured section is formed as a bottomed hole, for example. Since the shape of the cross-section of the uncured section reflects the shape of the mask, the cross-section of the bottomed hole can be determined depending on the shape of the mask. This results in an easier realization of the mass production of the molded product having the bottomed hole. Moreover, the adjustment of the intensity and the duration of emission for the light in the second direction can be utilized to determine the depth of the bottomed hole, for example. If the mask is finely formed, for example, it is possible to form a fine bottomed hole in an easier manner in a shorter time. Moreover, since the mask takes any shape, the bottomed hole can take a variety of shapes.

According to a third aspect of the present invention, there is provided a molding apparatus comprising: a mold defining a cavity, the mold at least partly having optical permeability; a light emission unit designed to emit a parallel beam to the mold; and a mask fixed to the mold at a position between the cavity and the light emission unit, the mask having optical impermeability.

When the light curing resin material is poured into the cavity of the mold in the molding apparatus, the parallel beam is emitted from the light emission unit. Since the mask having optical impermeability is fixed to the mold at a position between the cavity and the light emission unit, the parallel beam penetrates through the light curing resin material at a position off the mask. The light curing resin material gets cured at the position off the mask. The mold in this manner serves to form the contour of the molded product. On the other hand, an uncured section extending straight is formed in the light curing resin material behind the mask. When an uncured light curing resin material is removed from the uncured section in the light curing resin material, the uncured section provides a hole, for example. Since the shape of the uncured section depends on the shape of the mask, the shape of the hole is determined depending on the shape of the mask. The molded product having the hole can thus be mass-produced in a facilitated manner. When the mask is finely formed, for example, it is possible to form a fine hole in an easier manner in a shorter time. Moreover, since the mask takes any shape, the bottomed hole can take a variety of shapes.

### BRIEF DESCRIPTION OF THE DRAWINGS

Fig. 1 is a perspective view schematically illustrating a molded product according to an embodiment of the present invention.
Fig. 2 is a perspective view schematically illustrating the molded product.
Fig. 3 is an enlarged partial sectional view taken along the line 3-3 in Fig. 1.
Fig. 4 is an enlarged partial plan view of the moldedproduct for schematically illustrating the configuration of holes.
Fig. 5 is a schematic view of a molding apparatus according to a specific example.
Fig. 6 is a perspective view schematically illustrating a lower mold.
Fig. 7 is a perspective view schematically illustrating an upper mold.
Fig. 8 is a perspective view of the back surface of the upper mold for schematically illustrating a protrusion aggregation.
Fig. 9 is a schematic view illustrating a process of pouring an ultraviolet curing resin material into the lower mold.
Fig. 10 is a schematic view illustrating a process of superposing the upper mold on the front surface of the lower mold.
Fig. 11 is a schematic view illustrating a process of utilizing masks for blockage of light emitted to the ultraviolet curing resin.
Fig. 12 is a schematic view illustrating the ultraviolet curing resin material taken out of the mold.
Fig. 13 is a schematic view illustrating a process of removing the uncured portion of the ultraviolet curing resin material.
Fig. 14 is a schematic view illustrating a process of cutting of the individual molded product from a molded sheet.
Fig. 15 is a schematic view illustrating a process of placing a dry film and a mask on the surface of a glass material for making the lower mold.
Fig. 16 is a schematic view illustrating a process of subjecting the dry film to exposure and development with a mask on the surface of the glass material.
Fig. 17 is a schematic view illustrating a process of subjecting the surface of the glass material to electroforming process for forming a metallic material.
Fig. 18 is a schematic view illustrating the lower mold made out of the metallic material.
Fig. 19 is a schematic view illustrating a process of placing a dry film and a mask on the surface of a glass material for making the upper mold.
Fig. 20 is a schematic view illustrating a process of subjecting the dry film to exposure and development with the mask on the surface of the glass material.
Fig. 21 is a schematic view illustrating a process of subjecting the surfaces of the glass material and the dry film to electroforming process so as to form a metallic material.
Fig. 22 is a schematic view illustrating a process of subj ecting the surface of the metallic material to electroforming process so as to form a metallic material.
Fig. 23 is a schematic view illustrating a process of urging the surface of the metallic material against the surface of a glass material in a fluid state.
Fig. 24 is a schematic view illustrating a process of forming a photoresist material on the surface of the glass material.
Fig. 25 is a schematic view illustrating the upper mold made out of the glass material.
Fig. 26 is a schematic view illustrating a molding apparatus according to another specific example.
Fig. 27 is a schematic view illustrating a process of utilizing masks for blockage of light emitted to the ultraviolet curing resin material in a first direction and a process of emitting light to the masks in a second direction opposite to the first direction.
Fig. 28 is a schematic view illustrating a process of removing the uncured portion of the ultraviolet curing resin material.
Fig. 29 is a schematic view illustrating the ultraviolet curing resin material taken out of the mold.
Fig. 30 is a schematic view illustrating a process of utilizing masks for blockage of light emitted to the ultraviolet curing resin material in a first direction and a process of utilizing masks for blockage of light emitted in a second direction opposite to the first direction.

### BEST MODE FOR CARRYING OUT THE INVENTION

Description will be made below on the embodiment of the present invention with reference to the attached drawings.

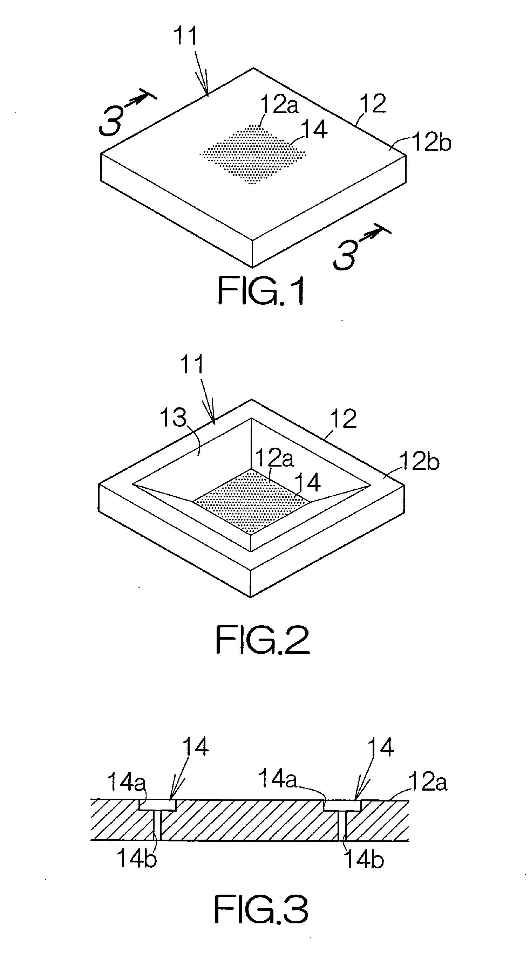

Fig.1 schematically illustrates a molded product 11 according to a specific example of the present invention. The molded product 11 serves as a capturing board designed to capture cells, for example. The molded product 11 includes a main body 12 made of a light curing resin. Here, an ultraviolet curing resin material may be employed as the light curing resin, for example. Referring also to Fig. 2, a depression 13 is formed in the back surface of the main body 12. The depression 13 serves to form a flat-plate section 12a and a frame section 12b in the main body 12. The frame section 12b surrounds the flat-plate section 12a.

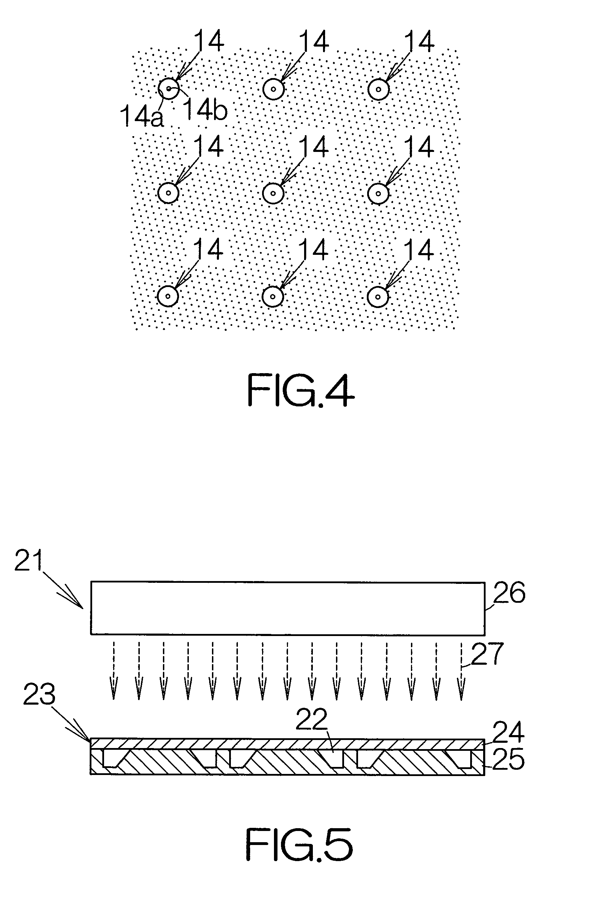

Fine through holes 14 are formed in the flat-plate section 12a. The through holes 14 are designed to penetrate from the front surface to the back surface of the flat-plate section 12a. Referring also to Fig. 3, the through holes 14 extend straight in parallel with each other in the flat-plate section 12a. Each through hole 14 has the circular cross-section, for example. The through hole 14 includes a large-diameter section 14a and a small-diameter section 14b. The large-diameter section 14a is located closer to the front surface of the flat-plate section 12a. The small-diameter section 14b is connected to the large-diameter section 14a and extends to reach the back surface of the flat-plate section 12a. The large-diameter section 14a and the small-diameter section 14b define cylindrical spaces, respectively. Here, the central axis of the large-diameter section 14a is aligned with the central axis of the small-diameter section 14b.

The diameter of the large-diameter section 14a is set at 10µm, for example. The depth or length of the large-diameter section 14a is set at 3µm, for example. The diameter of the small-diameter section 14b may be set at 10µm or smaller, for example. Here, the diameter of the small-diameter section 14b is set at 2µm, for example. The depth of the small-diameter section 14b is set at 7µm, for example. A cell has the size of 20 µm approximately, for example. The diameter of the through hole 14 may be set smaller than the size of the cell. The cells can in this manner be captured at the large-diameter section 14a of the through hole 14. The through holes 14 may be arranged at regular intervals, as shown in Fig. 4. It should be noted that the cross section of the through hole 14 may take a shape different from a circle. In this case, "diameter" corresponds to the maximum diameter of the through hole 14 regardless of the shape of the cross section of the through hole 14, for example.

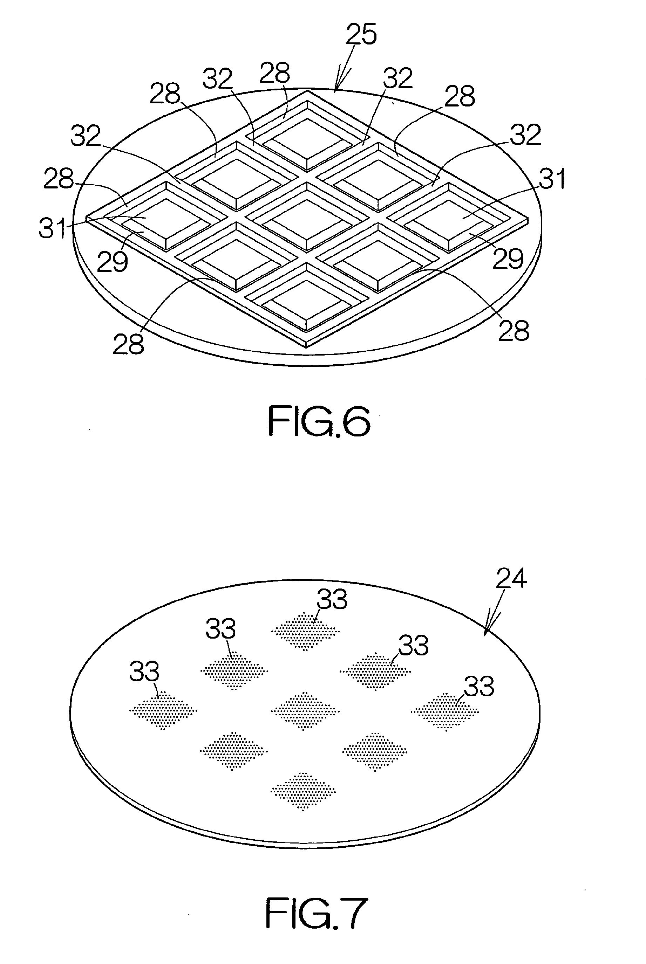

Next, a brief description will be made on a method of making the molded product 11. As shown in Fig. 5, a molding apparatus 21 is prepared in a method of making the molded product 11. The molding apparatus 21 includes a mold 23 defining a cavity 22 inside. The mold 23 includes an upper mold 24 and a lower mold 25. The front surface of the lower mold 25 receives the back surface of the upper mold 24. The upper mold 24 may be made of a glass material having optical permeability, for example. The lower mold 25 may be made of a metallic material, for example. The front surface of the lower mold 25 may be subjected to a surface treatment for absorption of light. The mold 23 at least partly has optical permeability in this manner.

The molding apparatus 21 also includes a light emission unit 26 opposed to the front surface of the mold 23 or upper mold 24 . The light emission unit 26 is designed to emit a parallel beam 27 to the mold 23. Ultraviolet rays may be employed as the parallel beam 27, for example. Here, the parallel beam 27 is emitted in the vertical direction perpendicular to the front surfaces of the upper and lower molds 24, 25. Since the upper mold 24 has optical permeability, the parallel beam 27 penetrate through the upper mold 24. Since the front surface of the lower mold 25 is subjected to a surface treatment for absorption of light, the parallel beam 27 is absorbed in the lower mold 25.

As shown in Fig. 6, the lower mold 25 is formed as a disk, for example. Depressions 28, 28, ... are defined in the front surface of the lower mold 25. The shape of the depression 28 corresponds to the contour of the molded product 11. The depressions 28 and the upper mold 24 in combination establish the aforementioned cavity 22. The protrusion 29 is defined in the depression 28. The protrusion 29 stands upright from the bottom surface of the depression 28. The contour of the protrusion 29 corresponds to the contour of the depression 13 of the molded product 11. A flat surface 31 is defined on the top surface of the protrusion 29. Partition walls 32 are defined in the lower mold 25 to separate the depressions 28 from each other.

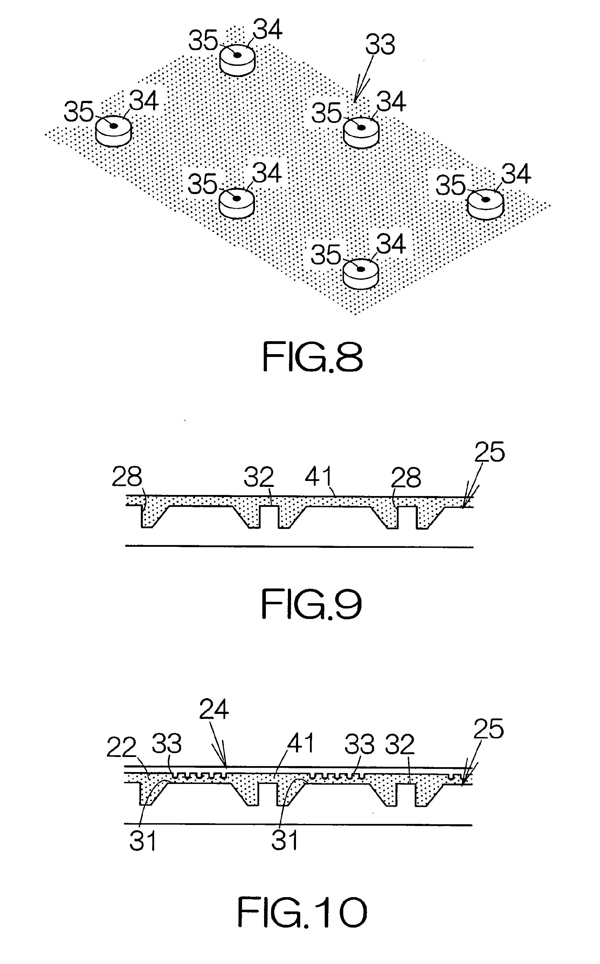

As shown in Fig. 7, the upper mold 24 is formed as a disk in the same manner as the lower mold 25, for example. Protrusion aggregations 33, 33, ... are defined in the back surface of the upper mold 24 . The configuration of the protrusion aggregations 33 corresponds to the mirror image of the configuration of the flat surfaces 31 of the lower mold 25. As shown in Fig. 8, the individual protrusion aggregation 33 includes protrusions 34, 34, ... standing upright from the back surface of the upper mold 24. The individual protrusion 34 is formed in the shape of a cylinder. The contour of the protrusion 34 corresponds to the contour of the large-diameter section 14a of the through hole 14. A mask 35 is fixed to the top surface of the individual protrusion 34. The mask 35 has optical impermeability. The mask 35 is contoured along a circle, for example. The diameter of the mask 35 corresponds to the diameter of the small-diameter section 14b of the through hole 14. The mask 35 may be made of Ti film, for example.

As shown in Fig. 9, an ultraviolet curing resin material 41 is poured into the depressions 28 of the lower mold 25. The upper mold 24 is then superposed on the front surface of the lower mold 25, as shown in Fig. 10. The protrusion aggregations 33 of the upper mold 24 are accurately aligned with the corresponding flat surfaces 31 of the lower mold 25. Here, predetermined spaces may be defined between the top surfaces of the partition walls 32 and the back surface of the upper mold 24. The ultraviolet curing resin material 41 is in this manner filled in a space between the back surface of the upper mold 24 and the front surface of the lower mold 25, that is, in the cavity 22.

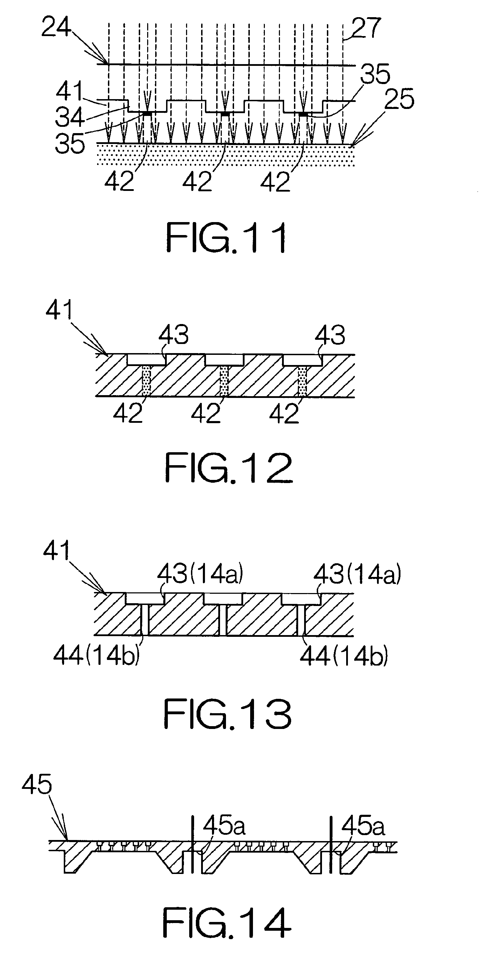

The parallel beam 27 is then emitted to the mold 23 from the light emission unit 26, as shown in Fig. 11. The parallel beam 27 is oriented in the vertical direction perpendicular to the front surfaces of the lower and upper molds 25, 24 as described above. Since the upper mold 24 is made of a glass material, the parallel beam 27 penetrates through the upper mold 24. The parallel beam 27 then penetrates through the ultraviolet curing resin material 41 at positions off the masks 35. The ultraviolet curing resin material 41 gets cured at the positions off the masks 35. The ultraviolet curing resin material 41 starts getting cured at an area closest to the light emission unit 26. The cured area gradually spreads in the overall ultraviolet curing resin material 41 as the distance gets larger from the light emission unit 26.

Since the masks 35 are placed between the cavity 22 and the light emission unit 26, the masks 35 block the parallel beam 27 directed to the ultraviolet curing resin material 41. Uncured sections 42 are formed behind the masks 35, that is, below the masks 35. The uncured sections 42 are designed to extend straight from the masks 35. Since the front surface of the lower mold 25 is subjected to a surface treatment for absorption of light, the parallel beam 27 is absorbed in the front surface of the lower mold 25. This results in prevention of reflection of the parallel beam 27 on the front surface of the lower mold 25. The parallel beam 27 thus fails to reach the uncured sections 42. When the section or sections other than the uncured sections 42 have completely been cured, the ultraviolet curing resin material 41 is taken out of the cavity 22.

As shown in Fig. 12, large-diameter sections 43 are formed in the ultraviolet curing resin material 41 based on the protrusions 34 of the upper mold 24. The large-diameter sections 43 correspond to the aforementioned large-diameter sections 14a of the through holes 14. Ultrasonic waves are then applied to the ultraviolet curing resin material 41 so as to clean the ultraviolet curing resin material 41, for example. As shown in Fig. 13, the ultraviolet curing resin material 41 is removed from the uncured sections 42. Through holes or small-diameter sections 44 are formed at the uncured sections 42 in this manner. The small-diameter sections 44 correspond to the aforementioned small-diameter sections 14b of the through holes 14.

As shown in Fig. 14, a molded sheet 45 has been made out of the ultraviolet curing resin material 41 in this manner. Since a predetermined space is defined between the top surfaces of the partition walls 32 and the back surface of the upper mold 24, narrow sections 45a are formed in the molded sheet 45. Cutting process or melting process is applied at the narrow sections 45a so as to separate the individual molded product 11 from the molded sheet 45. A dicing blade may be utilized in the cutting process, for example. A laser may be utilized to realize the melting process, for example. Alternatively, the molded product 11 may be cut off by hand. The thickness of the narrow sections 43a can be set based on the space between the top surfaces partition walls 32 and the back surface of the upper mold 24.

The method of making the molded product 11 allows establishment of the uncured sections 42 with the assistance of the masks 35. When the ultraviolet curing resin material 41 is removed from the uncured sections 42, the through holes can be formed. The through holes have the shape corresponding to the shape of the masks 35. The method allows establishment of a fine through hole in an easier manner in a shorter time as compared with a conventional method. In addition, the lower mold 25 and the upper mold 24 serve to form the contour of the molded product 11. This results in an easier realization of the mass production of the molded product 11 having the fine through holes.

Moreover, since the masks 35 are fixed to the upper mold 24, the uncured sections 42 can be formed at the same positions with accuracy in every molded product 11. The molded product 11 can be mass-produced as designed with a high accuracy in this manner. In addition, the masks 35 can take any shape. Since the cross-sectional shape of the uncured sections 42 reflects the shape of the masks 35, the fine through holes can take a variety of shapes depending on the shape of the masks 35. Furthermore, since the front surface of the lower mold 25 is subjected to a surface treatment for absorption of light, the parallel beam 27 is prevented from reflection from the lower mold 25. The parallel beam 27 fails to reach the uncured sections 42. The uncured sections 42 can be formed in the ultraviolet curing resin material 41 below the masks 35 with accuracy.

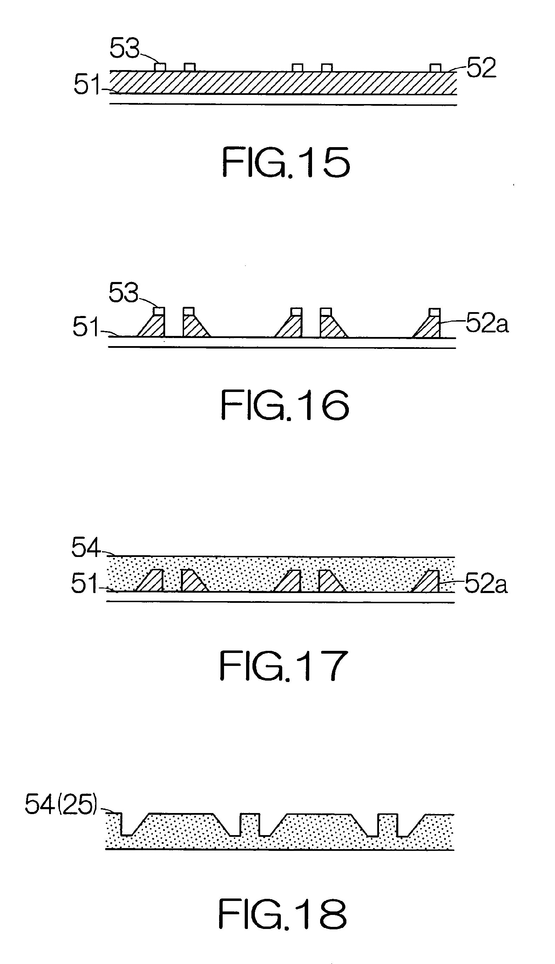

Next, a brief description will be made on a method of making the lower mold 25. As shown in Fig. 15, a glass material 51 is prepared. A dry film 52 is attached to the surface of the glass material 51. A mask 53 is placed on the surface of the dry film 52. The mask 53 is patterned in a predetermined shape. The dry film 52 is then subjected to exposure and development. The dry film 52a in this manner remains on the surface of the glass material 51 in a predetermined shape, as shown in Fig. 16. The glass material 51 and the dry film 52a in combination form a master mold for the lower mold 25. Specifically, the glass material 51 and the dry film 52a in combination define the contour of the front surface of the lower mold 25. The mask 53 is then removed from the dry film 52a. It should be noted that a photoresist solution may be utilized in place of the dry film 52.

A metallic material 54 is then formed on the surfaces of the glass material 51 and the dry film 52a, as shown in Fig. 17. A conventional electroforming process is utilized to form themetallicmaterial54, for example. The contour of the surface of the glass material 51 is printed on the metallic material 54. The metallic material 54 is thereafter separated from the glass material 51. As shown in Fig. 18, the lower mold 25 is made out of the metallic material 54 in this manner. The surface of themetallicmaterial 54 maybe subjected to a surface treatment for absorption of light. It should be noted that evaporating process may be applied to the surfaces of the glass material 51 and the dry film 52a so as to form a metallic thin film made of A1, Cr, or the like, not shown, on the surfaces of the glass material 51 and the dry film 52a prior to the electroforming process.

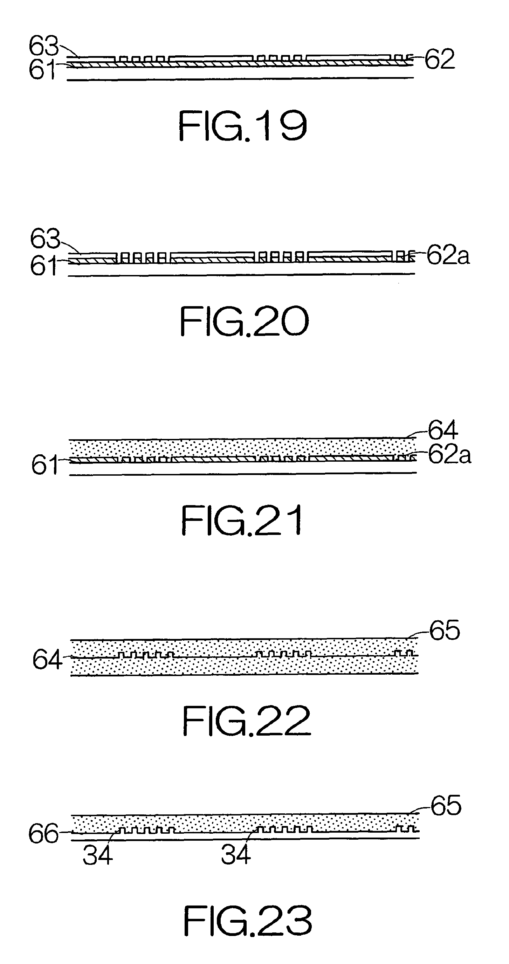

Next, a brief description will be made on a method of making the upper mold 24. As shown in Fig. 19, a glass material 61 is prepared. A dry film 62 is attached to the surface of the glass film 61. A mask 63 is placed on the surface of the dry film 62, for example. The dry film 62 is then subjected to exposure and development. As shown in Fig. 20, the dry film 62a in this manner remains on the surface of the glass material 61 in a predetermined shape. The glass material 61 and the dry film 62a in combination define the contour of the back surface of the upper mold 24. The mask 63 is then removed. It should be noted that a photoresist solution may be utilized in place of the dry film 62.

A metallic material 64 is then formed on the surfaces of the glass material 61 and the dry film 62a, as shown in Fig. 21. A conventional electroforming process is utilized to form the metallic material 64, for example. The contour of the surfaces of the glass material 61 and the dry film 62a is in this manner printed on the surface of the metallic material 64. The metallic material 64 is thereafter separated from the surfaces of the glass material 61 and the dry film 62a.

A metallic material 65 is then formed on the surface of the metallic material 64 as shown in Fig. 22. A conventional electroforming process is utilized to form the metallic material 65, for example. The contour of the surface of the metallic material 64 is printed on the surface of the metallic material 65. The metallic material 65 is thereafter separated from the metallic material 64. The metallic material 65 forms a master mold for the upper mold 24 in this manner. It should be noted that evaporating process may be applied to the surfaces of the glass material 61 and the dry film 62a as well as the surface of the metallic material 64 so as to form a metallic thin film made of A1, Cr or the like, not shown, on the surfaces of the glass material 61 and the dry film 62a as well as the surface of the metallic material 64 prior to the electroforming process.

The surface of the metallic material 65 is then urged against the surface of a glass material 66 in a fluid state, as shown in Fig. 23. The contour of the surface of the metallic material 65 is thus printed on the surface of the glass material 66. Here, the glass material 66 may be made of a material having optical permeability. The glass material 66 is then cooled, so that the glass material 66 gets cured. The aforementioned protrusions 34 are formed in the glass material 66. The glass material 66 is thereafter separated from the surface of the metallic material 65.

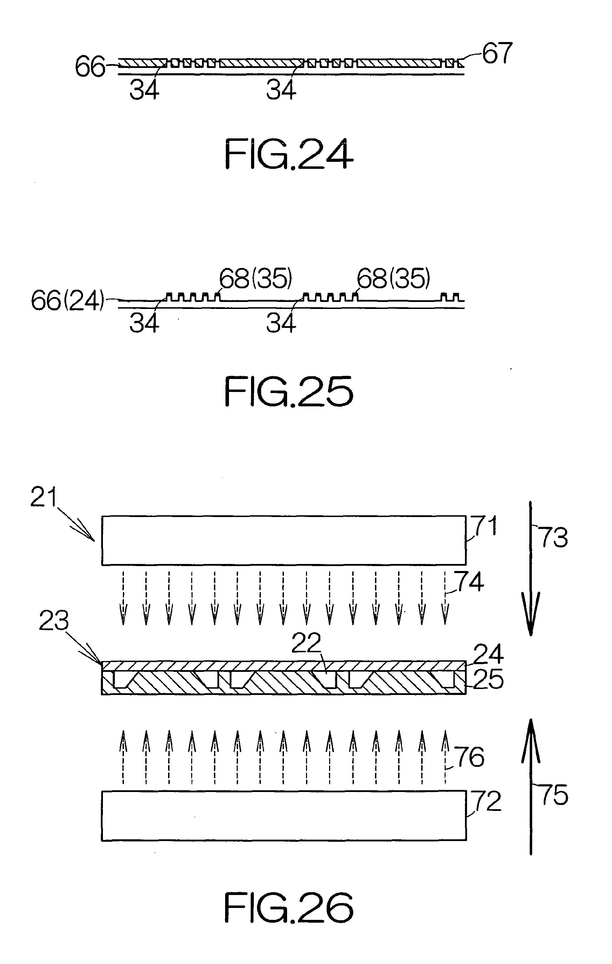

As shown in Fig. 24, a photoresist material 67 is then applied to the glass material 66. The photoresist material 67 is subjected to exposure and development. A mask, not shown, is used in the exposure and development, for example. The photoresist material 67 remains in a predetermined shape. The top surfaces of the protrusions 34 are exposed in a predetermined shape in the photoresist material 67. A metallic material, not shown, is thereafter evaporated on the photoresist material 67. Ti may be employed as the metallic material, for example. When the photoresist material 67 is removed, a Ti film 68, that is, the mask 35 is formed on the top surface of the individual protrusion 34, as shown in Fig. 25. The upper mold 24 is in this manner made out of the glass material 66.

As shown in Fig. 26, the molding apparatus 21 may include a first light emission unit 71 opposed to the front surface of the upper mold 24 and a second light emission unit 72 opposed to the back surface of the lower mold 25. The first light emission unit 71 is designed to emit a first parallel beam 74 in a first direction 73. The second light emission unit 72 is designed to emit a second parallel beam 76 in a second direction 75 opposite to the first direction 73. The first and second parallel beams 74, 76 are thus set parallel to each other. In this case, the lower mold 25 may be made of a glass material having optical permeability, for example. Like reference numerals are attached to the structure or components equivalent to those of the aforementioned embodiment.

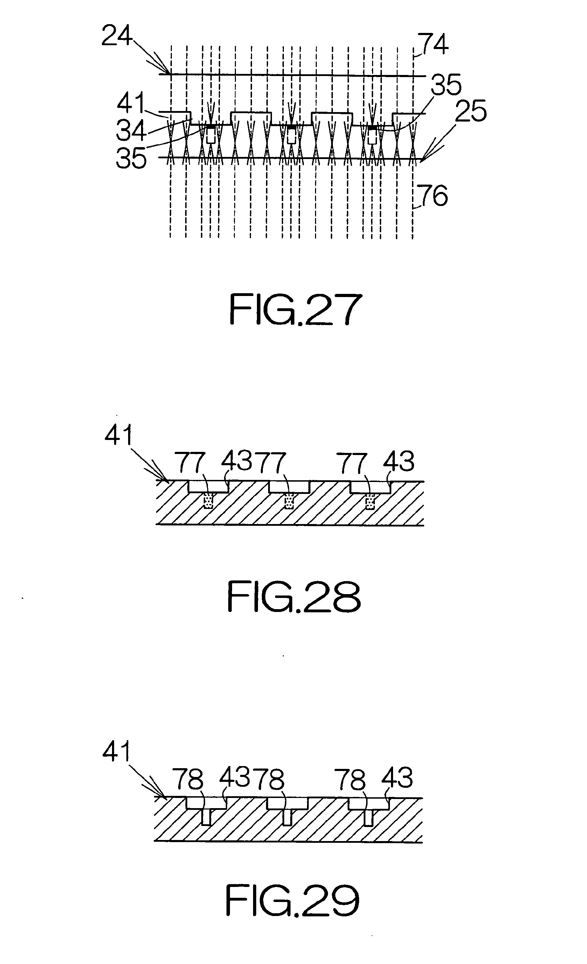

The ultraviolet curing resin material 41 is filled in a space between the back surface of the upper mold 24 and the front surface of the lower mold 25, that is, in the cavity 22 in the same manner as described above. As shown in Fig. 27, the first parallel beam 74 is emitted in the first direction 73 to the ultraviolet curing resin material 41 from the first light emission unit 71. The ultraviolet curing resin material 41 gets cured at positions off the masks 35. The ultraviolet curing resin material 41 starts getting cured at an area closest to the first light emission unit 71. The cured area gradually spreads in the overall ultraviolet curing resin material 41. Likewise, the second parallel beam 76 is emitted to the masks 35 and the ultraviolet curing resin material 41 from the second emission unit 72. The second parallel beam 76 serves to cure the ultraviolet curing resin material 41 behind the masks 35.

In this case, the second parallel beam 76 is subjected to adjustment of the intensity and the duration of emission. The ultraviolet curing resin material 41 starts getting cured at an area closest to the second light emission unit 72. The cured area gradually spreads in the ultraviolet curing resin material 41. The ultraviolet curing resin material 41 is thus cured behind the masks 35 within a predetermined distance from the back surface of the ultraviolet curing resin material 41. Uncured sections 77 are formed behind the masks 35, that is, below the masks 35 in this manner. When ultrasonic waves are applied to the ultraviolet curing resin material 41 so as to clean the uncured ultraviolet curing resin material 41 in the uncured sections 77, for example, bottomed holes 78 are formed at the uncured sections 77.

The method of making the molded product 11 allows establishment of the uncured sections 77 in the ultraviolet curing resin material 41 behind the masks 35 based on the irradiation of the first and second parallel beams 74, 76. When the ultraviolet curing resin material 41 is removed from the uncured sections 77, the bottomed holes 78 can be formed. The bottomed holes 78 have the shape corresponding to the shape of the masks 35. The method allows establishment of a fine bottomed hole in an easier manner in a shorter time. In addition, the lower mold 25 and the upper mold 24 serve to form the contour of the molded product 11. This results in an easier realization of the mass production of the molded product 11 having the bottomed holes 78. Moreover, the adjustment of the intensity and/or the duration of emission for the second parallel beam 76 enables determination of the extent of the curedultraviolet curing resin material 41, for example. The bottomed hole 78 is in this manner allowed to enjoy adjustment of the depth.

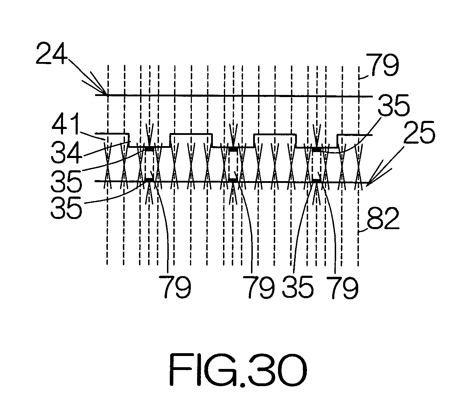

As shown in Fig. 30, the masks 35 having optical impermeability may be fixed on the front surface of the aforementioned lower mold 25. The location of the masks 35 on the lower mold 25 may be aligned with the masks 35 on the upper mold 24. Like reference numerals are attached to the structure or components equivalent to those of the aforementioned embodiments. The first parallel beam 74 in this manner serves to cure the ultraviolet curing resin material 41 at positions off the masks 35. Likewise, the second parallel beam 76 serves to cure the ultraviolet curing resin material 41 at positions off the masks 35. Since the location or configuration of the masks 35, 35 are aligned with each other, uncured sections 79 are formed between the opposed masks 35. When ultrasonic waves are applied to the ultraviolet curing resin material 41 so as to clean the uncured ultraviolet curing resin material 41 in the uncured sections 79, for example, through holes are formed at the uncured sections 79.

## Claims

1. A method of making a molded product, comprising:
pouring a light curing resin material into a mold;
emitting light to the light curing resin material, the light being partly blocked with a mask; and
removing an uncured portion of the light curing resin material, theuncuredportionremaininguncuredbasedonblockage of the light.

2. The method according to claim 1, further comprising absorbing the light that penetrates through the mold.

3. The method according to claim 1, wherein the mask is fixed to the mold for the blockage of the light.

4. The method according to claim 1, further comprising emitting light to the light curing resin material behind the mask.

5. A method of making a molded product, comprising:
pouring a light curing resin material into a mold;
emitting light to the light curing resin material in a first direction, the light being partly blocked with a mask; emitting light to the mask in a second direction opposite to the first direction; and
removing an uncured portion of the light curing resin material, theuncuredportionremaininguncuredbasedonblockage of the light.

6. The method according to claim 5, wherein the mask is fixed to the mold for blockage of the light.

7. A molding apparatus comprising:
a mold defining a cavity, the mold at least partly having optical permeability;
a light emission unit designed to emit a parallel beam to the mold; and
a mask fixed to the mold at a position between the cavity and the light emission unit, the mask having optical impermeability.
